(19) Europäisches Patentamt
European Patent Office
Office européen des brevets

(11) Veröffentlichungsnummer: **0 418 719 A1**

# (12) EUROPÄISCHE PATENTANMELDUNG

(21) Anmeldenummer: **90117563.8**

(22) Anmeldetag: **12.09.90**

(51) Int. Cl.⁵: **C08L 81/02**, C08L 73/00, C08L 79/08, C08L 81/06, C08K 3/26, C08K 7/14, C08J 5/00, C08J 5/18, D01F 6/74, D01F 6/76, D01F 6/94

(30) Priorität: **22.09.89 DE 3931649**

(43) Veröffentlichungstag der Anmeldung: **27.03.91 Patentblatt 91/13**

(84) Benannte Vertragsstaaten: **BE DE ES FR GB IT NL**

(71) Anmelder: **BASF Aktiengesellschaft**
**Carl-Bosch-Strasse 38**
**W-6700 Ludwigshafen(DE)**

(72) Erfinder: **Heinz, Gerhard, Dr.**
**Im Vogelsang 2**
**W-6719 Weisenheim(DE)**
Erfinder: **Muenstedt, Helmut, Dr.**
**An der Altenbach 41**
**W-6706 Wachenheim(DE)**
Erfinder: **Ittemann, Peter, Dr.**
**217 Manor House Mill**
**Fort Mill, S.C. 29715(US)**
Erfinder: **Eberle, Wolfgang, Dr.**
**Am Hemel 20**
**W-6500 Mainz 1(DE)**

## (54) Thermoplastische Formmassen aus faserverstärkten hochtemperaturbeständigen Thermoplasten.

(57) Thermoplastische Formmassen, enthaltend 10 bis 94 Gew.-% eines Polyaryletherketons, Polyarylensulfids oder Polyetherimids oder deren Mischungen, bis zu 80 Gew.-% eines Polyarylethersulfons, 3 bis 40 Gew.-% Glasfasern und 3 bis 25 Gew.-% eines Erdalkalimetallcarbonats.

EP 0 418 719 A1

# THERMOPLASTISCHE FORMMASSEN AUS FASERVERSTÄRKTEN HOCHTEMPERATURBESTÄNDIGEN THERMOPLASTEN

Die vorliegende Erfindung betrifft thermoplastische Formmassen im wesentlichen aus

10 bis 94 Gew.-% eines Polyaryletherketons, Polyarylensulfids oder Polyetherimids oder deren Mischungen (A)

0 bis 80 Gew.-% eines Polyarylethersulfons (B)

3 bis 40 Gew.-% Glasfasern (C) und

3 bis 25 Gew.-% eines Erdalkalimetallcarbonats (D).

Darüber hinaus betrifft die Erfindung die Verwendung der erfindungsgemäßen thermoplastischen Formmassen zur Herstellung von Fasern, Folien und Formkörpern sowie Substrate für Leiterplatten, die aus den erfindungsgemäßen Formmassen hergestellt werden.

Hochtemperaturbeständige Thermoplaste wie Polyaryletherketone, Polyarylensulfide, Polyetherimide und Polyarylethersulfone können aufgrund ihres Eigenschaftsspektrums in vielen Bereichen Anwendung finden.

In letzter zeit wurden insbesondere Anwendungen im Elektronikbereich, z.B. als Leiterplattensubstrate interessant, da gegenüber den bisher verwendeten duroplastischen Epoxyharzen die Verarbeitung deutlich einfacher ist.

Unmodifizierte hochtemperaturbeständige Thermoplaste lassen sich jedoch nur schwer metallisieren, da die Haftfestigkeit der aufgebrachten Metallschicht unzureichend ist.

So hat es nicht an Versuchen gefehlt, dieses Problem zu überwinden und es finden sich in der Literatur eine Reihe von Vorschlägen.

Bekannt ist beispielsweise, daß die Zugabe von Füllstoffen häufig eine Verbesserung bewirkt.

Aus der EP-A-283 914 sind Polyarylethersulfonmassen bekannt, die eine Füllstoffmischung aus Wollastonit und einem Erdalkalimetallcarbonat enthalten.

In der JP-A 62/241 390 sind Polyarylethersulfone beschrieben, die eine Mischung aus Glasfasern und einem Erdalkalimetallcarbonat enthalten und die besonders als Substrate für Leiterplatten geeignet sind.

Gegenstand der EP-A-224 236 sind Mischungen aus Polyarylethersulfonen und Polyaryletherketonen, die einen faserförmigen Füllstoff enthalten.

Alle diese bekannten Formmassen können jedoch insgesamt noch nicht voll befriedigen. So werden zwar mit Massen gemäß der JP-A-62/241 390 gute Haftfestigkeiten bei der Metallisierung erhalten, doch ist für manche Anwendungen die Temperaturbeständigkeit verbesserungsbedürftig.

Die Mischungen gemäß der EP-A-224 236 besitzen zwar eine bessere Temperaturbeständigkeit, doch die Haftfestigkeit einer Metallschicht nach der Metallisierung ist nicht voll zufriedenstellend.

Augabe der vorliegenden Erfindung war es daher, thermoplastische Formmassen zur Verfügung zu stellen, die sich durch eine gute Temperaturbeständigkeit bei guter Metallisierung auszeichnen.

Diese Aufgabe wird erfindungsgemäß durch die eingangs angegebenen thermoplastischen Formmassen gelöst.

Als Komponente A enthalten die erfindungsgemäßen thermoplastischen Formmassen 10 bis 94, vorzugsweise 15 bis 70 und insbesondere 20 bis 60 Gew.-% eines Polyaryletherketons, Polyarylensulfids, Polyetherimids oder deren Mischungen.

Polyaryletherketone sind an sich bekannt und in der Literatur beschrieben. Beispielsweise kann auf die EP-A-1879 und die EP-A-265 842 hingewiesen werden. Entsprechend der EP-A-265 842 haben erfindungsgemäß verwendbare Polyaryletherketone beispielsweise wiederkehrende Einheiten der Formeln I und/oder II

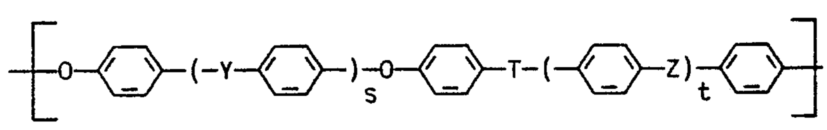
I

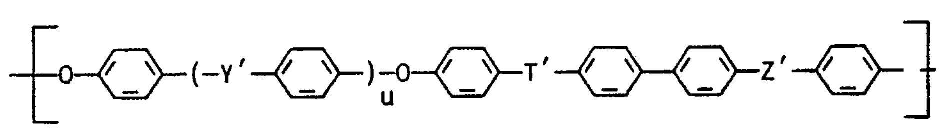
II

oder deren kernsubstituierten $C_1$-$C_6$-Alkyl-, $C_1$-$C_6$-Alkoxy-, Phenyl-, Chlor- oder Fluorderivate,

wobei

Y, Y', T, T', Z und Z' jeweils -CO-, CR'R'', eine chem. Bindung oder -O-sein können und mindestens einer der Substituenten Y, T und Z bzw. Y', T' und Z' -CO- ist R' und R'' jeweils Wasserstoffatome, $C_1$-$C_6$-Alkyl- oder Alkoxygruppen, Arylgruppen oder deren Fuor- oder Chorderivate darstellen, und s, t und u jeweils den Wert 0 oder 1 haben.

Beispiele für Einheiten der allgemeinen Formel I und II sind:

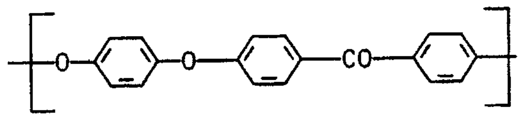

(I,1)

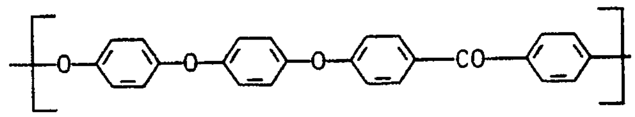

(I,2)

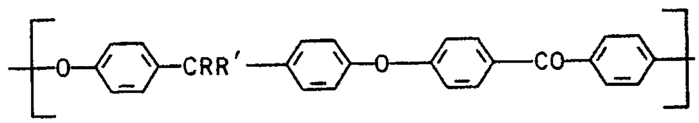

(I,3)

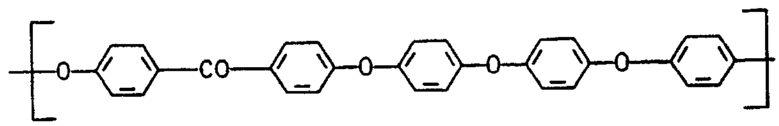

(I,4)

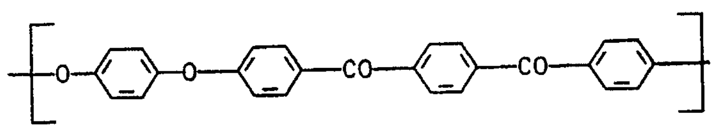

(I,5)

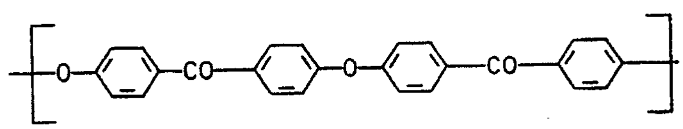

(I,6)

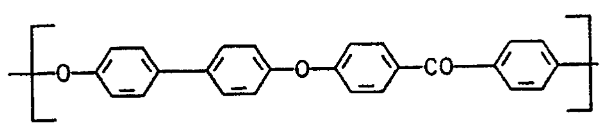

(I,7)

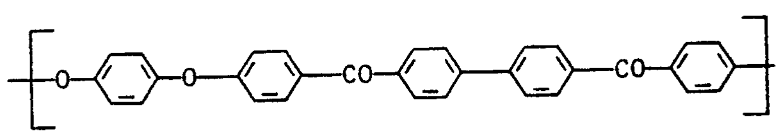

(II,1)

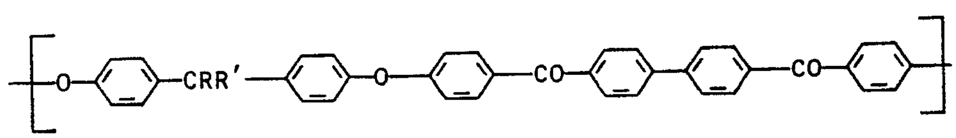

(II,2)

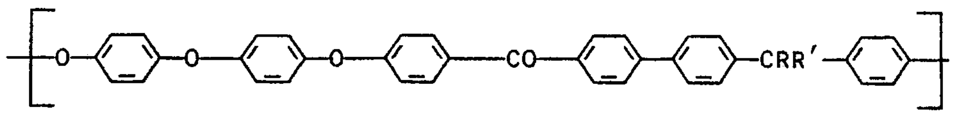

(II,3)

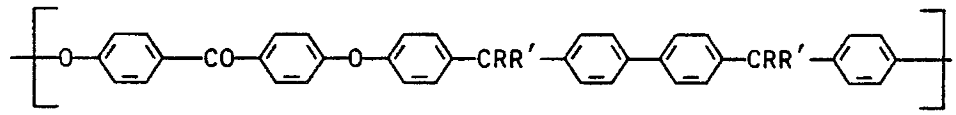

(II,4)

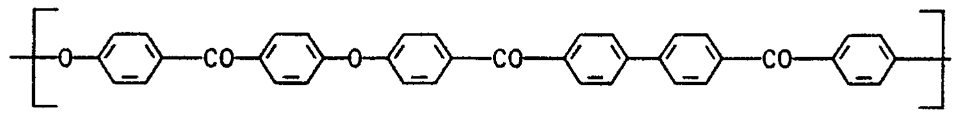

(II,5)

wobei dies nur eine Auswahl nur für die unter die allgemeinen Formeln I und II fallenden Einheiten darstellt. über die Substituenten Y, T, Z bzw. Y', T' und Z' und die Parameter s, t und u lassen sich die vorstehenden Beispiele wie folgt beschreiben:

| | s | t | Y | T | Z |
|---|---|---|---|---|---|
| I,1 | 0 | 0 | - | -CO- | - |
| I,2 | 1 | 0 | -O- | -CO- | - |
| I,3 | 1 | 0 | -CRR'- | -CO- | - |
| I,4 | 1 | 1 | -CO- | -O- | -O- |
| I,5 | 0 | 1 | - | -CO- | -CO- |
| I,6 | 1 | 0 | -CO- | -CO- | - |
| I,7 | 1 | 0 | chem. Bdg. | -CO- | - |

| | u | Y' | T' | Z' |
|---|---|---|---|---|
| II,1 | 0 | - | -CO- | -CO- |
| II,2 | 1 | -CRR'- | -CO- | -CO- |
| II,3 | 1 | -O- | -CO- | -CRR'- |
| II,4 | 1 | -CO- | -CRR'- | -CRR'- |
| II,5 | 1 | -CO- | -CO- | -CO- |

Obwohl, wie bereits erwähnt, grundsätzlich beliebige Kombinationen der Substituenten Y, T und Z bzw. Y', T' und Z' möglich sind, werden im allgemeinen solche Einheiten bevorzugt, in denen T und Z bzw. T' und Z' gleich sind, da die entsprechenden Monomeren in der Regel leichter zugänglich sind.

Verfahren zur Herstellung derartiger Polyaryletherketone sind an sich bekannt und z.B. in der EP-A-1879, WO-A 84/03891, US-A-3 441 538, und der US-A-3 953 400 beschrieben. Grundsätzlich ist sowohl die nukleophile als auch die elektrophile Polykondensation möglich.

Polyarylensulfide, die ebenfalls als Komponente A) eingesetzt werden können, sind an sich ebenfalls bekannt und beispielsweise unter der Bezeichnung Ryton® im Handel erhältlich.

Im allgemeinen werden zur Herstellung ein Alkalimetallsulfid und eine aromatische Verbindung mit mindestens zwei Halogenatomen am aromatischen Ring in Gegenwart einer geeigneten polaren organischen Verbindung umgesetzt, wie z.B. in der US-A-3 354 129 beschrieben. Das dabei entstehende Polymer besteht im wesentlichen aus den durch 5-Atome verknüpften aromatischen Ringen der eingesetzten Dihalogenverbindung.

Bevorzugte Polyarylensulfide sind solche der allgemeinen Formel

-A-S-

wobei A eine Phenyl, Naphthyl- oder Diphenylengruppe ist, die ggf. mit $C_1$-$C_4$-Alkylgruppen substituiert sein kann. Besonders bevorzugtes Polyarylensulfid ist Polyphenylensulfid (PPS).

Die ebenfalls als Komponente A) verwendbaren Polyetherimide sind im wesentlichen aus wiederkehrenden Einheiten der Formel III

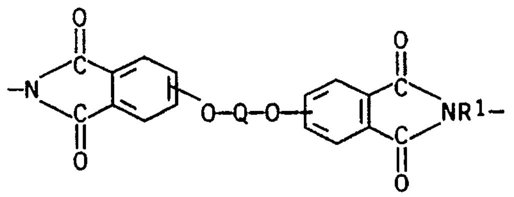

III

aufgebaut, wobei Q einen zweiwertigen aromatischen organischen Rest mit 6 bis 30 C-Atomen und $R^1$ einen zweiwertigen organischen Rest, bestehend aus

a) aromatischen Kohlenwasserstoffen mit 6 bis 20 C-Atomen und/oder deren halogenierten Derivaten,

b) Alkylenresten, Polydiorganosiloxanresten und Cycloalkylenresten mit bis zu 20 C-Atomen oder

c) zweiwertigen Resten der Formel

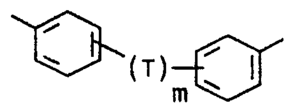

wobei -(T)-

—O— , 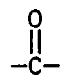 , 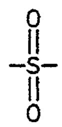 , —S— oder $-C_nH_{2n}-$ (n = 1 bis 5) ist

und m einen Wert von 0,1 oder 2 hat, darstellen.

Besonders bevorzugt werden Produkte, in denen $R^1$ die vorstehend genannte Bedeutung hat und Q einen zweiwertigen Rest des Bisphenols A bedeutet.

Verfahren zur Herstellung von Polyetherimiden sind z.B. aus der DE-C-23 63 785, der DE-C-24 37 286 und der DE-C- 24 41 539 bekannt.

Es versteht sich, daß auch Mischungen aus zwei oder drei der vorstehend genannten hochtemperaturbeständigen Polymeren eingesetzt werden können.

Als Komponente B) können die erfindungsgemäßen Formmassen noch bis zu 80, vorzugsweise 10 bis 75 und insbesondere 20 bis 60 Gew.-% eines Polyarylethersulfons enthalten.

Entsprechende Produkte sind ebenfalls bekannt und z.T. kommerziell erhältlich. Nur beispielsweise sei hier auf Polyarylethersulfone mit wiederkehrenden Einheiten verwiesen, die man erhält, wenn man in den vorstehend für die Polyaryletherketone genannten Formeln -CO- durch $-SO_7-$ ersetzt. Verfahren zur Herstellung derartiger Produkte sind allgemein bekannt und z.B. in der DE-B-15 45 106, der EP-A-113 112 und der EP-A-185 130 beschrieben.

Als Komponente C) enthalten die erfindungsgemäßen Formmassen 3 bis 40, vorzugsweise 5 bis 30 und insbesondere 10 bis 30 Gew.-% Glasfasern. Diese können ggf. mit einer Schlichte und/oder Haftvermittlern ausgerüstet sein. Der Durchmesser der Glasfasern liegt im allgemeinen im Bereich von 6 bis 20 µm, die mittlere Länge im fertigen Spritzgußteil vorzugsweise im Bereich von 0,08 bis 0,5 mm.

Als Erdalkalimetallcarbonat D) können die Carbonate des Magnesiums-, Calciums, Strontiums und Bariums eingesetzt werden, wobei Calcium- und Magnesiumcarbonat sowie deren eutektisches Gemisch, der sog. Dolomit, bevorzugt werden. Der Anteil der Komponente D beträgt 3 bis 25, vorzugsweise 3 bis 20 und insbesondere 5 bis 20 Gew.-% bezogen auf das Gesamtgewicht der Formmasse.

Neben den Komponenten A) bis D) können die erfindungsgemäßen Formmassen noch übliche Zusatzstoffe und Verarbeitungshilfsmittel enthalten. Nur beispielsweise seien hier Antioxidantien, Wärmestabilisatoren, UV-Stabilisatoren, Schmiermittel, Formtrennmittel und Farbstoffe und Pigmente genannt.

Verfahren zur Herstellung der erfindungsgemäßen Formmassen sind dem Fachmann an sich bekannt und in der Literatur beschrieben, so daß sich hier nähere Angaben erübrigen.

Vorzugsweise werden die Komponenten in einem Extruder oder einer entsprechenden Mischvorrichtung durchmischt, extrudiert und granuliert. Anschließend können dann im Spritzguß Formkörper hergestellt

werden.

Ein wichtiger Vorteil der erfindungsgemßen Formmassen besteht darin, daß sich auf daraus hergestellten Formkörpern nach bekannten Verfahren Metallschichten mit sehr guter Haftfestigkeit aufbringen lassen, die der von metallisierten Polyethersulfonen mit der gleichen Füllstoffkombination nicht nachstehen, diesen aber in der Wärmebeständigkeit überlegen sind.

Entsprechende Verfahren zur Metallisierung sind an sich bekannt und in der bereits erwähnten EP-A-283 914 beschrieben, auf die hier wegen näherer Einzelheiten verwiesen wird.

## Ansprüche

1. Thermoplastische Formmassen, enthaltend
   A: 10 bis 94 Gew.-% eines Polyaryletherketons, Polyarylensulfids oder Polyetherimids oder deren Mischungen A
   B: 0 bis 80 Gew.-% eines Polyarylethersulfons B
   C: 3 bis 40 Gew.-% Glasfasern C und
   D: 3 bis 25 Gew.-% eines Erdalkalimetallcarbonats D.
2. Thermoplastische Formmassen nach Anspruch 1, gekennzeichnet durch folgende Gehalte
   A: 15 bis 70 Gew.-% A
   B: 10 bis 75 Gew.-% B
   C: 5 bis 30 Gew.-% C
   D: 3 bis 20 Gew.-% D
3. Verwendung der thermopastischen Formmassen gemäß den Ansprüchen 1 bis 2 zur Herstellung von Fasern, Folien und Formkörpern.
4. Substrat für Leiterplatten, erhalten aus thermoplastischen Formmassen gemäß den Ansprüchen 1 bis 2.

Europäisches Patentamt

# EUROPÄISCHER RECHERCHENBERICHT

Nummer der Anmeldung

EP 90117563.8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl⁵) |
|---|---|---|---|
| X | EP - B1 - 0 111 327 (AMOCO CORPORATION) * Ansprüche; Seite 2, Zeilen 46,47; Seite 10, Zeilen 20-22 * | 1-4 | C 08 L 81/02<br>C 08 L 73/00<br>C 08 L 79/08<br>C 08 L 81/06<br>C 08 K 3/26<br>C 08 K 7/14<br>C 08 J 5/00<br>C 08 J 5/18<br>D 01 F 6/74<br>D 01 F 6/76<br>D 01 F 6/94<br>H 05 K 1/03 |
| X | DE - A1 - 3 735 465 (BAYER AG) * Anspruch; Seite 3, Zeilen 1-8 * | 1,3 | |
| X | EP - A2 - 0 297 363 (BASF AKTIENGESELLSCHAFT) * Ansprüche; Seite 10, Zeilen 12-25 * | 1-3 | |
| X | EP - A2 - 0 103 869 (PHILLIPS PETROLEUM COMPANY) * Ansprüche * | 1 | |
| X | EP - B1 - 0 103 149 (PHILLIPS PETROLEUM COMPANY) * Seite 3, Zeilen 9-12; Beispiel B * | 1,3,4 | RECHERCHIERTE SACHGEBIETE (Int Cl⁵) |
| X | US - A - 4 340 697 (AYA et al.) * Zusammenfassung; Spalte 17, Zeilen 5-23; Spalte 18, Zeilen 18-27 * | 1-3 | C 08 L 73/00<br>C 08 L 79/00<br>C 08 L 81/00<br>C 08 K<br>C 08 J<br>D 01 F<br>H 05 K |
| P,X | EP - A2 - 0 358 135 (IDEMITSU KOSAN COMPANY LIMITED) * Ansprüche; Seite 5, Zeile 42 - Seite 6, Zeile 5 * | 1,3 | |

Der vorliegende Recherchenbericht wurde für alle Patentansprüche erstellt.

| Recherchenort | Abschlußdatum der Recherche | Prüfer |
|---|---|---|
| WIEN | 03-12-1990 | WEIGERSTORFER |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82